# FASCICULE DE BREVET EUROPEEN

(11) **EP 4 075 479 B1**
(45) Date de publication et mention de la délivrance du brevet: **29.10.2025**
(21) Numéro de dépôt: 22167773.5
(22) Date de dépôt: 12.04.2022
(51) Int. Cl.: H01L 21/02

(54) **STRUCTURE COMPOSITE, DESTINÉE À UNE CO-INTÉGRATION PLANAIRE DE COMPOSANTS ÉLECTRONIQUES DE FONCTIONS DIFFÉRENTES**
VERBUNDSTRUKTUR, DIE FÜR EINE PLANARE KO-INTEGRATION VON ELEKTRONISCHEN KOMPONENTEN MIT UNTERSCHIEDLICHEN FUNKTIONEN BESTIMMT IST
COMPOSITE STRUCTURE, INTENDED FOR A PLANAR CO-INTEGRATION OF ELECTRONIC COMPONENTS WITH VARIOUS FUNCTIONS

(30) Priorité: 16.04.2021 FR 2103985
(43) Date de publication de la demande: 19.10.2022
(73) Titulaire: Commissariat à l'Energie Atomique et aux Energies Alternatives, 75015 Paris (FR)
(72) Inventeur: ROUMANIE, Marilyne, 38054 Grenoble cedex 9 (FR); NAVONE, Christelle, 38054 Grenoble cedex 09 (FR); BENAISSA, Lamine, 38054 Grenoble cedex 09 (FR)
(74) Mandataire: Germain Maureau

(56) Documents cités:
- US-A1- 2011 073 236
- US-A1- 2017 062 357
- US-A1- 2020 365 532

## Description

La présente invention se rapporte aux substrats avancés pour le domaine de la microélectronique, de la photonique, et de l'électronique de puissance. En particulier, la présente invention concerne une structure composite, destinée à une co-intégration planaire de composants électroniques de fonctions différentes, et son procédé de fabrication.

Afin d'améliorer les performances des dispositifs électroniques, la technologie de fabrication des composants électroniques CMOS (Complementary Metal Oxide Semiconductor) s'est peu à peu détournée de l'utilisation de substrats massifs pour s'orienter vers des substrats à film mince, reporté via une couche d'oxyde enterrée, permettant un meilleur contrôle électrostatique du canal des transistors MOS en évitant les courants de fuite. Toutefois, cette technologie FDSOI (Fully Depleted Silicon On Insulator) est limitée lorsque l'on souhaite placer plusieurs transistors sur un même substrat. Il est en effet nécessaire de créer des tranchées d'isolation STI (Shallow Trench Isolation) dans le substrat entre chacun des transistors. De plus, lorsqu'on souhaite disposer des composants de fonctions différentes, par exemple un transistor à conduction verticale et un capteur RF (RadioFréquence) sur un même substrat, les besoins relatifs aux propriétés du substrat d'intégration diffèrent. Le transistor aura besoin d'un substrat conducteur tandis que le capteur RF devra bénéficier d'un substrat électriquement isolant, présentant une bonne conductivité thermique et capable d'une limitation des pertes RF.

Pour tenir compte de ces contraintes, une méthode connue consiste en l'utilisation de composants discrets, sur substrat propre. Chacun des composants (RF et transistors) est alors réalisé sur un substrat spécifique et différent. Puis chaque composant est découpé pour être prélevé puis reporté sur un support et connecté, ce qui est long et couteux.

Il est fait également référence aux documents suivants:
US 2017/062357 A1 (KAMGAING TELESHPOR [US] ET AL) 2 mars 2017;
US 2011/073236 A1 (LEE SANG IN [US]) 31 mars 2011;
US 2020/365532 A1 (MALE BARRY JON [US] ET AL) 19 novembre 2020.

Un des buts de la présente invention vise à pallier au moins l'un de ces inconvénients. L'invention est définie par les caractéristiques techniques divulguées dans les revendications indépendantes.

A cet effet, la présente invention propose une structure composite, destinée à une co-intégration planaire de composants électroniques de fonctions différentes, la structure composite comprenant de sa base vers sa surface :
- un substrat support en un premier matériau, le substrat support comportant des cavités débouchant chacune dans une face supérieure du substrat support, les cavités étant comblées par au moins un matériau composite constitué d'une matrice d'un polymère précéramique réticulé, la matrice étant chargée de particules inorganiques,
- un film mince en un deuxième matériau, le film mince étant collé à la face supérieure du substrat support et au matériau composite.

Ainsi configurée, la structure composite de la présente invention présente un substrat support comprenant une alternance de régions constituées de différents matériaux aux propriétés également différentes. Le substrat support comprend en effet des régions comportant un matériau composite dont les particules permettent de moduler ses propriétés, notamment sa conductivité électrique. Aussi, le film mince sus-jacent rend possible l'intégration dans le plan de plusieurs composants électroniques aux besoins et aux fonctionnements différents, selon que l'on se trouve au-dessus du premier matériau ou du matériau composite. Ceci permet d'optimiser le fonctionnement de chacun des composants, et de limiter la durée de fabrication nécessaire par comparaison à l'art antérieur lorsque les différents composants sont fabriqués sur des substrats différents puis reportés sur un support unique. Par ailleurs, le choix d'un matériau composite formé à partir d'un polymère précéramique permet de garantir une absence de désagrégation ou de décomposition lors d'étapes de fabrication ou d'utilisation ultérieures de la structure à haute température. En effet, après le traitement de réticulation, le polymère précéramique mis en forme devient infusible.

Avantageusement, les cavités d'un même substrat support peuvent être comblées par des natures de matériaux composites différentes tant en terme de polymère précéramique qu'en termes de nature et de combinaison de particules inorganiques. Ainsi, la structure composite peut être entièrement conçue en adaptant les propriétés du matériau composite dans les cavités selon les besoins des composants à intégrer.

Selon une disposition, les cavités présentent une profondeur supérieure ou égale à 10 micromètres, notamment supérieure ou égale à 50 micromètres et par exemple environ 100 micromètres.

Cette profondeur permet avantageusement de s'affranchir de l'effet du substrat support se trouvant directement sous les cavités. Ces dimensions sont éloignées de celles obtenues avec des technologies de microélectronique classique (par évaporation CVD, PVD,...) où les épaisseurs sont généralement inférieures à 5µm, ce qui rend la structure composite de la présente invention plus efficace.

Selon une possibilité, les cavités présentent une largeur allant de 100 micromètres à 1 mm. Ces dimensions sont accessibles par les technologies habituelles de la microélectronique.

Avantageusement, les cavités présentent une forme globale variable, telle une forme de polygone, de cylindre... elles peuvent présenter une section transversale circulaire de dimensions variables, etc, la forme de la cavité étant configurée pour rendre possible un comblement à partir d'une formulation de comblement liquide ou solide par des techniques conventionnelles.

Selon une disposition, le polymère précéramique est un polymère à base de silicium. Le polymère précéramique est de préférence choisi parmi le groupe comprenant un polysiloxane, un polysilsesquioxane, un polycarbosiloxane, un polycarbosilane, un polysilylcarbodiimide, un polysilsesquicarbodiimide, un polysilsesquiazane, un polysilazane, un polyborosilazane, un polyborosilane, un polyborosiloxane et une combinaison de ces polymères. Le choix de la nature du polymère précéramique dépend des propriétés visées pour la structure composite souhaitée et de sa compatibilité avec le substrat sur lequel il est déposé. Il est également choisi pour qu'une fois chargé et réticulé, le matériau composite résultant présente un coefficient de dilatation thermique proche de celui du film mince composé de préférence par du silicium.

Le polymère précéramique présente une excellente tenue à la température (il résiste par exemple sous forme de colle à des températures supérieures à 350°C). Ceci permet à la couche mince transférée de subir des traitements thermiques à haute température, comme une guérison des défauts générés par l'implantation dans le substrat donneur par exemple. En effet, un polymère précéramique est un polymère organique/inorganique qui est généralement utilisé afin de réaliser après traitement thermique à haute température des objets céramiques dit PDC (acronyme anglosaxon de « Polymer Derived Ceramics »).

Un tel polymère précéramique peut être appliqué sous forme diverse et peut donc facilement être utilisé pour remplir des cavités aux dimensions sus mentionnées. Il se présente sous forme liquide ou est soluble dans des solvants organiques et peut être déposé sur un substrat par voie liquide, solide ou en phase vapeur.

Il est possible d'utiliser toutes les techniques de mise en forme de polymères telles que l'enduction centrifuge (spin coating), l'enduction par trempage (dip coating), la pulvérisation ou le coulage en bande, la sérigraphie, l'impression jet d'encre.

Selon une possibilité, la matrice est chargée d'un ou de plusieurs types de particules inorganiques, choisis parmi :
- un conducteur thermique, tel que le SiC,
- un isolant électrique, tels que l'AIN, le Si₃N₄, l'Al₂O₃ cristallin ou le BN,
- un métal conducteur électrique, tel que Cu, Ag, Au ou AI,
- un matériau magnétique, tels que NdFeB, la ferrite de ZnMn ou de NiZn,
- un matériau à propriété optique, notamment du CdSe sous forme de nanoparticules de 2 à 8 nm, de sorte à obtenir des propriétés de fluorescence ou du graphite pour des propriétés de reflexion,
et une combinaison de ces différents types de particules inorganiques.

Ce choix aussi important de particules permet d'accéder à un grand nombre de matériaux composites aux propriétés très variées. Ceci permet une très bonne adaptation aux besoins des différents composants électroniques à intégrer. En effet, le choix de ces particules inorganiques permet de conférer au matériau composite respectivement des propriétés de conductivité thermique, d'isolation électrique, de conductivité électrique, de propriétés magnétiques et/ou des propriétés optiques différentes de celles du polymère précéramique et du premier matériau.

Il par ailleurs est possible d'utiliser des matrices contenant plusieurs tailles et formes de particules inorganiques pour favoriser les chemins de percolation.

De préférence, la matrice est obtenue à partir d'une formulation de comblement, comprenant entre 20% à 50% en volume de polymère précéramique et un taux de charge en particules inorganiques allant de 50 et 80% en volume par rapport au volume total de la formulation de comblement.

Dans le cas de particules inorganiques de SiC (densité 3.21) le rapport massique de SiC varie dans une plage allant de 71 à 91% pour un poids de polymère précéramique allant de 9 à 29%. Ces particules sont de préférence mélangées avec la matrice de manière à ce que la formulation de comblement présente un taux de charges suffisant pour obtenir les propriétés souhaitées et pour obtenir une couche intègre en fonction de l'épaisseur de dépôt et de la température de travail.

Selon une possibilité, le film mince est collé à la face supérieure du substrat support et au matériau composite par l'intermédiaire d'un primaire d'accroche. Le primaire d'accroche est ainsi disposé entre la face supérieure du substrat support (et une surface exposée du matériau composite comblant les cavités) et le film mince.

Le primaire d'accroche de la présente invention est un polymère précéramique dont la viscosité est adaptée au moyen de mise en forme. Il ne se dégrade ou ne se décompose pas à de hautes températures et est compatible avec une utilisation dans la fabrication de dispositifs électroniques. Un solvant peut être ajouté pour moduler la viscosité. Il peut être déposé par dispense de type jet d'encre ou sérigraphie. Dans le cas où le polymère précéramique est solide (initialement ou partiellement réticulé), celui-ci présente un comportement thermoplastique. Le primaire d'accroche est ainsi capable d'être ramolli, au moins en surface, ce qui permet le collage au substrat donneur du film mince.

Avantageusement, le primaire d'accroche utilisé est de la même nature que le polymère précéramique utilisé pour la matrice. Ce primaire d'accroche a alors l'avantage d'être compatible avec la matrice et de favoriser une bonne accroche. Il est choisi parmi les polysiloxanes qui sont avantageusement compatibles avec la surface d'un substrat en silicium et aux températures élevés puisqu'ils se transforment en céramique.

De préférence, le primaire d'accroche est choisi parmi le SILRES^{®} H62 C (résine de silicone phénylique) et le SILRES^{®} MK (résine de silicone méthylique) disponibles auprès du fournisseur Wacker Chemie AG.

Selon un autre aspect, la présente invention propose un système micro-électronique à co-intégration planaire comprenant :
- une structure composite telle que précédemment décrite
- une pluralité de composants électroniques de fonctions différentes sur le film mince, comprenant :
   o des composants électroniques passifs, tels que des composants RF, par exemple des capteurs, formés sur des premières régions de la surface exposée du film mince situées à l'aplomb du matériau composite comblant les cavités du substrat support,
   o des composants électroniques actifs, tel que des transistors associés aux composants RF, formés sur des deuxièmes régions de la surface exposée du film mince situées à l'aplomb du premier matériau du substrat support,
les particules inorganiques de la matrice sont constituées de SiC et/ou de Si₃N₄ pour conférer un caractère conducteur thermique et isolant électrique au matériau composite comblant les cavités.

Ainsi, le matériau composite est réalisé en un matériau compatible en terme de coefficient de dilation thermique CTE avec la couche mince (cette propriété étant également fonction de l'épaisseur de dépôt) et modulable en termes de propriétés électriques et thermiques en fonction de la charge ajoutée. Ceci va permettre d'envisager pour la structure résultante des opérations technologiques impliquant des budgets thermiques importants et notamment des températures pouvant aller jusque 1000° C voire au-delà.

Le matériau composite peut être différent selon les cavités comblées, de sorte que l'intégration d'autres composants électroniques aux fonctions différentes est envisageable sur la structure composite.

Selon d'autres caractéristiques, la structure de la présente invention comporte une ou plusieurs des caractéristiques optionnelles suivantes considérées seules ou en combinaison :
- Le premier matériau, c'est-à-dire le matériau du substrat support, est un matériau semi-conducteur, tel que du silicium.
- le premier matériau est du silicium monocristallin.
- le premier matériau est du silicium polycristallin ou amorphe.
- le premier matériau comprend du SiC, Ge, InP, et /ou de l'AsGa.
- Le substrat support présente une épaisseur comprise entre 10 micromètres et 1 mm.
- Le substrat support est un wafer (plaquette) standard de silicium. Il présente typiquement une épaisseur de 725 micromètres pour un diamètre de 200 mm.
- La profondeur de chacune des cavités est strictement inférieure à l'épaisseur du substrat support.
- Le substrat donneur ou le film mince est réalisé à partir d'un deuxième matériau monocristallin, semi-conducteur, tel que le silicium, le SiC, le Ge, l'InP, ou l'AsGa ou présentant des propriétés piézoélectriques, tel que le PZT, BaTiO3, LiNbO₃, quartz, ou LiTaO3.
- La qualité cristalline du substrat support est moindre à celle du film mince.
- L'épaisseur du film mince est comprise entre 10 nm et 2 micromètres lorsqu'il est obtenu par formation d'un plan de fragilisation dans un substrat donneur, suivie d'une fracture.
- L'épaisseur du film mince est au minimum de 100 micromètres lorsqu'il est obtenu par amincissement par grinding d'un substrat donneur plus épais (terme communément utilisé par l'homme de l'art pour désigner un meulage ou une rectification).
- Le deuxième matériau du film mince sert de couche germe pour une croissance épitaxiale lors de la fabrication partielle ou totale de composants.
- Les particules inorganiques chargées dans la matrice présentent un diamètre allant du nanomètre à plusieurs micromètres.
- Le film mince est collé par un collage direct, c'est-à-dire par adhésion moléculaire, avec le substrat support et le matériau composite.
- Des couches de SixOy et/ou de SixNy sont déposées à l'interface de collage pour favoriser le collage direct. Ces couches présentent une épaisseur comprise entre 0,1 et 5 micromètres.
- Le film mince est collé par un collage métallique avec le substrat support et le matériau composite.
- Des couches métalliques de Cu, Ag et/ou W sont déposées à l'interface de collage pour favoriser le collage métallique.
- Le film mince est collé par un collage hybride avec le substrat support et le matériau composite.
- Le film mince est collé par un collage SAB (acronyme anglosaxon pour activation ionique sous ultra-vide) avec le substrat support et le matériau composite.
- Avant mise en contact en vue du collage, une chimie est effectuée sur les surfaces afin d'éliminer les particules résiduelles et les oxydes natifs.
- Dans le cas d'un collage direct, les techniques de plasma (plasma O₂ ou N₂), UV/ozone et Megpie sont utilisées.

Selon un autre aspect, l'invention propose un procédé de fabrication d'une structure composite destinée à une co-intégration planaire, le procédé comprenant les étapes de :
- a) fourniture d'un substrat support en un premier matériau, comprenant une face supérieure, le substrat support comprenant des cavités débouchant dans la face supérieure,
- b) comblement des cavités par une formulation de comblement comprenant une matrice d'un polymère précéramique, la matrice étant chargée de particules inorganiques,
- c) application d'un traitement de réticulation de sorte à obtenir un matériau composite constitué de la matrice du polymère précéramique réticulé, chargée en particules inorganiques,
- d) collage d'un substrat donneur en un deuxième matériau à la face supérieure du substrat support et au matériau composite, et
- e) amincissement du substrat donneur pour former un film mince.

Le comblement des cavités par la formulation de comblement est réalisé par toute technique usuelle de la microélectronique. Il peut être obtenu par sérigraphie ou par jet d'encre ou par toute méthode en accord avec les dimensions des cavités. Dans le cas où la formulation de comblement est sous forme solide et en particulier de poudres granulées ou de granulés, cette dernière peut être dispensée dans des cavités par extrusion à l'aide d'une seringue (type procédé de robocasting).

Selon une disposition, le traitement de réticulation comprend un traitement thermique.

Lorsque la formulation de comblement comprend un solvant, l'étape c) d'application d'un traitement de réticulation comprend au préalable un traitement thermique d'évaporation à une temprétaire inférieure à celle du traitement thermique de réticulation de sorte de sorte à permettre l'évaporation du solvant de la formulation de comblement.

Selon une variante de réalisation, l'application du traitement de réticulation comprend l'application d'une rampe de température permettant de réaliser le traitement thermique d'évaporation. La rampe de température est réalisée avec ou sans pallier selon la nature du solvant utilisé et sa quantité de sorte à évaporer la totalité du solvant.

Selon une possibilité, l'étape d) de collage est précédée d'une étape i) de planarisation de la surface supérieure du substrat support et/ou d'une surface exposée du matériau composite, de sorte que la surface exposée et la surface supérieure s'étendent dans un unique plan et forment une surface adaptée au collage.

L'étape i) de planarisation comprend une étape de meulage et/ou d'application d'un polissage mécano-chimique de sorte à présenter un surface de la rugosité souhaitée selon le type de collage. La rugosité sera sera par exemple inférieure à 0.5 nm RMS pour la réalisation d'un collage direct.

Selon une disposition, l'étape d) de collage est précédée d'une étape j) de dépôt comprenant la formation d'un primaire d'accroche sur la surface supérieure du substrat support et sur la surface exposée du matériau composite et/ou sur le substrat donneur, de sorte à faciliter le collage. Dans ce cas, l'étape i) de planarisation est moins contraignante, il est meme parfois possible de s'y soustraire selon la rugosité initiale des surfaces.

Le primaire d'accroche formé sur la/le(s) surface(s) avant collage présente une épaisseur inférieure à 10 micromètres. Ceci permet de niveler les surfaces sans pour autant avoir d'impact négatif sur les propriétés de la structure composite.

Selon une possibilité, le procédé comprend le réalisation d'une étape k) de préparation de la face supérieure entre l'étape b) et l'étape c) comprenant :
- la disposition et le maintien d'un élément couvrant contre la face supérieure du substrat support, en couvrant au moins les cavités,
- le retournement du substrat support, de sorte que la formulation de comblement vient par gravité affleurer le plan de la face supérieure du substrat support.

Ainsi positionnée, la matrice se place contre la paroi interne de l'élément couvrant ou reste en sa position initiale dans laquelle il affleure le plan de la face supérieure du substrat support avant réticulation, selon le remplissage de la cavité. Dans ces conditions, le retrait du matériau composite lié à l'évaporation du solvant ou la réticulation n'affecte pas la différence de niveau entre le plan de la surface exposée du matériau composite et celui de la face supérieure du substrat support.

Il est entendu dans le présent document que le retournement conduit à l'inversion de la position de la face supérieure avec celle de la base du substrat support.

Une fois la reticulation effectuée selon l'étape c), le substrat support est retourné dans sa position initiale, la face supérieure orientée vers le haut. L'élement couvrant est retiré. La surface exposée du materiau composite et la face supérieure forment un unique plan formant une surface adaptée au collage. En effet lors la réticulation du polymère, des interactions se sont produites entre la matrice et les surfaces de la cavité de sorte que le matériau composite reste dans la position prise au moment de la réticulation malgré le retrait éventuel.

Selon une possibilité, au moins un orifice traversant est ménagé au préalable dans le substrat support de sorte à permettre l'evaporation d'un éventuel solvant de la formulation composite, depuis la cavité vers la base du substrat support orientée vers le haut.

L'élement couvrant comprend par exemple un film adhésif ou une contre-plaque, maintenu contre la face supérieure du substrat support.

La surface de collage ainsi formée est planarisée selon l'étape i) si nécessaire. Un dépôt d'un primaire d'accroche selon l'étape j) est également possible séparement ou en combinaison.

D'autres aspects, buts et avantages de la présente invention apparaîtront mieux à la lecture de la description suivante des différentes variantes de réalisation de celle-ci, données à titre d'exemple non limitatif et fait en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques dans lesquelles:
[Fig. 1] représente une étape du procédé selon un premier mode de réalisation de la structure composite 100 selon la présente invention.
[Fig. 2] représente une étape du procédé selon le premier mode de réalisation de la présente invention.
[Fig. 3] représente une étape du procédé selon le premier mode de réalisation de la présente invention.
[Fig. 4] représente une étape du procédé selon le premier mode de réalisation de la présente invention.
[Fig. 5] représente une étape du procédé selon le premier mode de réalisation de la présente invention.
[Fig. 6] représente une étape du procédé selon le premier mode de réalisation de la présente invention.
[Fig. 7] illustre une étape du procédé selon un deuxième mode de réalisation de la structure composite 100 de la présente invention.
[Fig. 8] illustre une deuxième étape du procédé selon le deuxième mode de réalisation de la présente invention.
[Fig. 9] illustre une troisième étape du procédé selon le deuxième mode de réalisation de la présente invention.

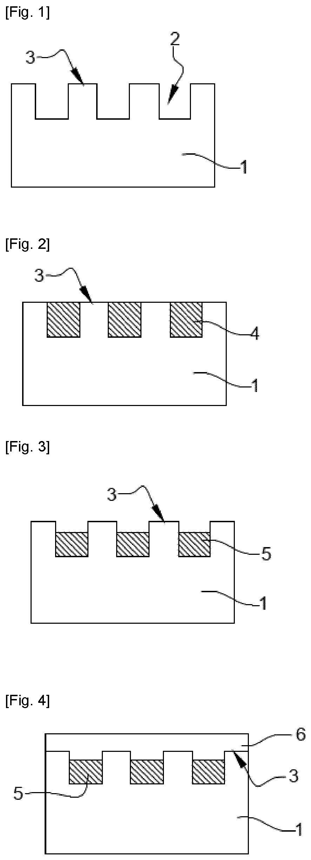

Comme illustré sur la figure 1, un substrat support 1 en un premier matériau semi-conducteur, telle qu'une plaquette de silicium de 725 micromètre d'épaisseur, est tout d'abord fourni selon l'étape a) du procédé. Il comporte une pluralité de cavités 2 débouchant chacune dans la face supérieure 3 du substrat support 1.

Ces cavités 2 ont été formées au préalable, par exemple par un procédé comprenant une étape de masquage comportant le dépôt de résine de photolithographie sur les régions du substrat support 1 à conserver, suivie d'une étape de gravure profonde par RIE des régions non masquées. Selon une alternative, les cavités 2 sont obtenues grâce à l'utilisation d'un laser jusqu'à atteindre une profondeur d'environ 100 micromètres et une section de 1x1 mm².

Comme illustré à la figure 2, les cavités 2 sont ensuite comblées par une formulation de comblement comprenant une matrice 4 d'un polymère précéramique chargée de particules inorganiques selon l'étape b) du procédé. Le remplissage ou le comblement des cavités 2 est réalisé alors que la face supérieure 3 du substrat support 1 comprend encore la résine de photolithographie de sorte à protéger la surface. Selon une variante, la protection est obtenue par un film adhésif de type sticky de découpe ou un pochoir de sérigraphie.

Selon une possibilité, la formulation de comblement comprend le polymère polysiloxane SILRES^{®} H62 C. Selon une autre disposition, le polymère est du polycarbosilane SMP-10 fourni par Starfire.

Les particules inorganiques sont constituées de Si₃N₄ et/ou d'AIN de sorte à conférer des propriétés thermiques et d'isolation électrique au matériau composite. Le taux de charge est d'environ de 60% du volume total de la formulation.

Un solvant, tel que le xylène, le butan-2-one ou le Diestone DLS, est ajouté à la matrice 4 de sorte à adapter la viscosité et obtenir une formulation de comblement liquide.

Le comblement des cavités 2 par la formulation de comblement est ensuite obtenu selon l'étape b) du procédé par sérigraphie.

Un traitement de réticulation selon l'étape c) du procédé est réalisé par application d'un traitement thermique à environ 200°C lorsque le polymère est du SILRES^{®} H62 C. Ce traitement thermique participe également à l'évaporation du solvant (visible figure 3). Un matériau composite 5 est alors obtenu dans les cavités 2.

Selon une possibilité, la formulation de comblement comprend au plus 30 % en poids de solvant de sorte à présenter une très bonne fluidité. Toutefois, une telle quantité de solvant génère un retrait (ou perte de volume) important de matériau composite 5 une fois le solvant évaporé et le polymère précéramique réticulé. Afin d'obtenir un comblement satisfaisant des cavités 2, une séquence comprenant un traitement thermique à une température inférieure à celle de la réticulation et le remplissage de la cavité par la formulation de comblement est répétée plusieurs fois, de sorte à combler au moins à 95% le volume des cavités 2 par le matériau composite 5. Ce taux de comblement diminue les étapes ultérieures de planarisation ou de préparation des surfaces pour un collage optimal avec le film mince.

Selon une variante non illustrée, la formulation de comblement est solide. Le polymère précéramique est du SILRES^{®} MK , il est dissous dans un solvant afin d'être mélangé à des particules de Si₃N₄. L'ensemble est ensuite séché pour l'obtention d'une poudre (formulation de comblement) utilisée pour combler les cavités 2. Un traitement thermique de réticulation permet d'obtenir le matériau composite 5. Selon une autre variante, le polymère précéramique solide est chauffé jusqu'à sa température de fusion (inférieure à sa température de réticulation) pour être mélangé aux particules inorganiques. Une fois la formulation refroidie et solidifiée, elle est broyée pour être introduite dans les cavités 2.

Comme représenté sur la figure 4, après retrait de la résine de photolithographie ou du film adhésif, un primaire d'accroche 6 est déposé sur la face supérieure 3 du substrat support 1 et la surface exposée du matériau composite 5 selon l'étape j) du procédé de sorte à éviter des étapes très importantes de meulage/planarisation des surfaces avant collage. Ce primaire d'accroche 6 est constitué d'un polymère précéramique au comportement thermoplastique de sorte qu'une fois déposé et chauffé à sa température de ramollissement, il permet un collage sur un substrat donneur selon l'étape d) du procédé.

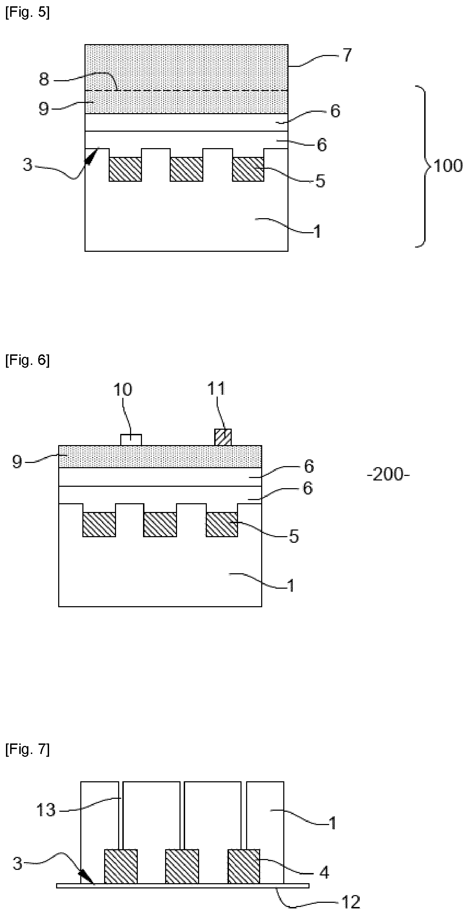

Selon une possibilité illustrée à la figure 5, le primaire d'accroche 6 est également déposé sur le substrat donneur 7 avant l'étape d) de collage. En variante il peut n'être déposé que sur ce substrat donneur et pas sur la face supérieure du substrat support 1.

Selon une autre possibilité non illustrée, le collage selon l'étape d) est réalisé par le dépôt au préalable d'une fine couche de silicium amorphe bombardée par de l'argon (collage SAB).

Selon encore une variante, le collage n'utilise pas de primaire d'accroche 6. La face du substrat support 1 et une surface exposée du matériau composite 5 sont planarisées par des étapes de meulage (grinding) et polissage mécano-chimique (CMP) de sorte à former un unique plan, formant une surface adaptée au collage ultérieur. Par exemple, en prévision d'un collage direct, ladite surface est polie jusqu'à présenter une rugosité inférieure à 0.5 micromètre RMS. La zone écrouie par le meulage a été retirée.

Comme visible à la figure 5, le substrat donneur 7 présente un plan de fragilisation 8 obtenu préalablement au collage par implantation d'espèces ioniques selon la technologie Smart Cut^{®}. Une fois le collage effectué, le film mince 9 est séparé du négatif du substrat donneur 7 par application d'un budget thermique de fracture selon l'étape e) du procédé. Celui-ci peut être diminué par l'application concomitante d'une contrainte mécanique au niveau du plan de fragilisation 8.

De préférence le substrat donneur 7 et/ou le film mince 9 est constitué d'un matériau monocristallin.

Des couches d'oxydes SixOy sont déposées par PEVCD sur les surfaces à coller sur une épaisseur d'environ 100 nm en vue d'un collage direct du substrat support 1 et du substrat donneur 7. Une étape de CMP est réalisée sur les couches d'oxydes pour retrouver la rugosité de surface nécessaire au collage direct, par exemple 0.3 micromètre RMS. Après mises en contact des surfaces, un recuit de collage renforçant l'énergie de collage entre le substrat donneur 7 et le substrat support 1 est appliqué. Ce recuit apporte avantageusement le budget thermique nécessaire à la fracture du substrat donneur 7 au niveau du plan de fragilisation 8 et libère le film mince 9 collé sur le substrat support 1. La surface du film mince 9 est polie et nettoyée pour la fabrication des composants électroniques 10,11 (figure 6)

Selon une autre alternative, le substrat donneur 7 non fragilisé est aminci par une étape de grinding (meulage), pouvant être associée à une gravure chimique, jusqu'à atteindre l'épaisseur souhaitée du film mince 9. Puis un polissage mécanochimique est réalisé notamment pour obtenir une surface du film mince 9 apte à une croissance épitaxiale d'un nouveau matériau. La structure composite 100 ainsi obtenue est capable d'une co-intégration planaire de différents composants électroniques sur des régions au propriétés différentes selon qu'elles sont situées sur le matériau composite 5 ou sur le premier matériau. (Système microélectronique 200 à co-intégration planaire sur la figure 6).

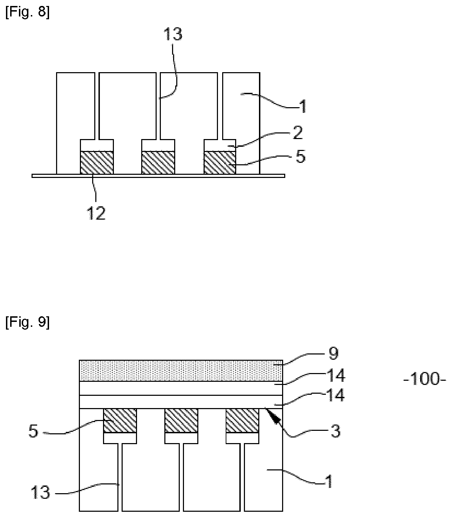

Selon une variante du procédé illustrée aux figures 7 à 9, une fois que la formulation de comblement est introduite dans les cavités 2, un élément couvrant 12, tel qu'une contre-plaque est disposée contre la face supérieure 3 du substrat support 1 de sorte à couvrir les cavités 2. Le substrat support 1 est ensuite retourné de sorte que sa face supérieure 3 soit orientée vers le bas et sa base soit orientée vers le haut, la contre-plaque 12 maintenant la formulation dans la cavité 2 (figure 7). Dans cette position la formulation de comblement 4 vient au contact de la paroi interne de la contre-plaque 12 de sorte à affleurer le plan de la face supérieure 3 du substrat support 1. Le traitement de réticulation est appliqué de sorte que le polymère de la formulation composite est réticulé dans cette position. Une fois le substrat support 1 retourné dans sa position initiale, la surface exposée du matériau composite 5 affleure le plan de la face supérieure 3 (figure 8). Un plan unique est ainsi formé, ce qui limite les étapes de planarisation ou de préparation des surfaces avant collage (figure 9).

Selon une possibilité illustrée à la figure 7, des orifices traversant 13 sont ménagés au préalable au travers l'épaisseur du substrat support 1 de sorte à permettre l'évaporation du solvant de la formulation de comblement, le cas échéant, des cavités 2 vers l'extérieur du substrat support 1. La contre plaque 12 est ensuite retirée, un collage direct avec des couches d'oxyde 14 est réalisé de sorte à obtenir la structure composite 100. Différents composants électroniques sont formés sur les différentes régions du film mince 9 selon que les régions sont sus jacentes des cavités 2 ou du premier matériau.

La structure composite 100 de la présente invention permet ainsi la co-intégration facilitée de composants au fonctions différentes tout en améliorant leurs performances grâce à un substrat sous-jacent configuré pour présenter les propriétés adaptées. Ces structures 100 permettent d'atteindre des systèmes 200 plus compacts, nécessitant moins d'étapes de fabrication que celles connues à ce jour.

## Revendications

1. Structure composite (100), destinée à une co-intégration planaire de composants électroniques de fonctions différentes, la structure composite (100) comprenant de sa base vers sa surface :
- un substrat support (1) en un premier matériau semi-conducteur, le substrat support (1) comportant des cavités (2) débouchant chacune dans une face supérieure (3) du substrat support (1), les cavités (2) étant comblées par au moins un matériau composite (5) constitué d'une matrice (4) d'un polymère précéramique réticulé, la matrice (4) étant chargée de particules inorganiques,
- un film mince (9) en un deuxième matériau semi-conducteur ou piézoélectrique, le film mince (9) étant collé à la face supérieure (3) du substrat support (1) et au matériau composite (5).

2. Structure composite (100) selon la revendication 1, dans laquelle les cavités (2) présentent une profondeur supérieure ou égale à 10 micromètres.

3. Structure composite (100) selon la revendication 1 ou 2, dans laquelle le polymère précéramique est un polymère à base de silicium, et de préférence choisi parmi le groupe comprenant un polysiloxane, un polysilsesquioxane, un polycarbosiloxane, un polycarbosilane, un polysilylcarbodiimide, un polysilsesquicarbodiimide, un polysilsesquiazane, un polysilazane, un polyborosilazane, un polyborosilane, un polyborosiloxane et une combinaison de ces polymères.

4. Structure composite (100) selon l'une des revendications 1 à 3, dans laquelle la matrice (4) est chargée d'un ou de plusieurs types de particules inorganiques, choisis parmi :
- un conducteur thermique, tel que le SiC,
- un isolant électrique, tels que l'AIN, le Si₃N₄, l'Al₂O₃ cristallin ou le BN,
- un métal conducteur électrique, tel que Cu, Ag, Au ou AI,
- un matériau magnétique, tels que NdFeB, la ferrite de ZnMn ou la ferrite de NiZn,
- un matériau à propriété optique,
et une combinaison de ces différents types de particules inorganiques.

5. Structure composite (100) selon l'une des revendications 1 à 4, dans laquelle la matrice (4) est obtenue à partir d'une formulation de comblement, comprenant entre 20% à 50% en volume de polymère précéramique et un taux de charge en particules inorganiques allant de 50 et 80% en volume par rapport au volume total de la formulation de comblement.

6. Structure composite (100) selon l'une des revendications 1 à 5, dans laquelle le film mince (9) est collé à la face supérieure (3) du substrat support (1) et au matériau composite (5) par l'intermédiaire d'un primaire d'accroche (6) disposé sur la face supérieure (3) du substrat support (1) et sur une surface exposée du matériau composite (5) comblant les cavités (2).

7. Système micro-électronique (200) à co-intégration planaire comprenant :
- une structure composite (100) selon l'une des revendications 1 à 6,
- une pluralité de composants électroniques de fonctions différentes sur le film mince (9) comprenant :
o des composants électroniques passifs (11), tels que des composants RF, par exemple des capteurs, formés sur des premières régions de la surface exposée du film mince (9) situées à l'aplomb du matériau composite (5) comblant les cavités (2) du substrat support (1),
o des composants électroniques actifs (10), tel que des transistors associés aux composants RF, formés sur des deuxièmes régions de la surface exposée du film mince (9) situées à l'aplomb du premier matériau du substrat support (1),
les particules inorganiques de la matrice (4) sont constituées de SiC et/ou de Si₃N₄ pour conférer un caractère conducteur thermique et isolant électrique au matériau composite (5) comblant les cavités (2).

8. Procédé de fabrication d'une structure composite (100) destinée à une co-intégration planaire, le procédé comprenant les étapes de :
- a) fourniture d'un substrat support (1) en un premier matériau, comprenant une face supérieure (3), le substrat support (1) comprenant des cavités (2) débouchant dans la face supérieure (3),
- b) comblement des cavités (2) par une formulation de comblement comprenant une matrice (4) d'un polymère précéramique, la matrice (4) étant chargée de particules inorganiques,
- c) application d'un traitement de réticulation de sorte à obtenir un matériau composite (5) constitué de la matrice (4) du polymère précéramique réticulé, chargée en particules inorganiques,
- d) collage d'un substrat donneur (7) en un deuxième matériau à la face supérieure (3) du substrat support (1) et au matériau composite (5), et
- e) amincissement du substrat donneur (7) pour former un film mince (9).

9. Procédé de fabrication selon la revendication 8, dans lequel l'étape d) est précédée d'une étape i) de planarisation de la face supérieure (3) du substrat support (1) et/ou d'une surface exposée du matériau composite (5), de sorte que la surface exposée et la face supérieure (3) s'étendent dans un unique plan, et forment une surface adaptée au collage.

10. Procédé de fabrication selon la revendication 8 ou 9, dans lequel l'étape d) est précédée d'une étape j) de dépôt comprenant la formation d'un primaire d'accroche (6) sur la face supérieure (3) du substrat support (1) et de la surface exposée du matériau composite (5) et/ou sur le substrat donneur (7), de sorte que le collage du substrat donneur (7) au substrat support (1) et au matériau composite (5) est obtenu par l'intermédiaire d'un primaire d'accroche (6).

11. Procédé de fabrication selon l'une des revendications 8 à 10, comprenant la réalisation d'une étape k) de préparation de la face supérieure (3) entre l'étape b) et l'étape c) comprenant :
- la disposition et le maintien d'un élément couvrant (12) contre la face supérieure (3) du substrat support (1), en couvrant au moins les cavités (2),
- le retournement du substrat support (1), de sorte que la formulation de comblement vient par gravité affleurer le plan de la face supérieure (3) du substrat support (1).

## Patentansprüche

1. Verbundstruktur (100), die für eine planare Kointegration von elektronischen Komponenten mit unterschiedlichen Funktionen bestimmt ist, wobei die Verbundstruktur (100) von ihrer Basis zu ihrer Oberfläche hin Folgendes umfasst:
- ein Trägersubstrat (1) aus einem ersten Halbleitermaterial, wobei das Trägersubstrat (1) Hohlräume (2) aufweist, die jeweils in eine Oberseite (3) des Trägersubstrats (1) münden, wobei die Hohlräume (2) mit mindestens einem Verbundmaterial (5) gefüllt sind, das aus einer Matrix (4) aus einem vernetzten präkeramischen Polymer besteht, wobei die Matrix (4) mit anorganischen Partikeln beladen ist,
- einen Dünnfilm (9) aus einem zweiten Halbleiter- oder piezoelektrischen Material, wobei der Dünnfilm (9) mit der Oberseite (3) des Trägersubstrats (1) und dem Verbundmaterial (5) verklebt ist.

2. Verbundstruktur (100) nach Anspruch 1, wobei die Hohlräume (2) eine Tiefe von größer gleich 10 Mikrometern aufweisen.

3. Verbundstruktur (100) nach Anspruch 1 oder 2, wobei das präkeramische Polymer ein siliziumbasiertes Polymer ist, und bevorzugt ausgewählt ist aus der Gruppe, die Polysiloxan, Polysilsesquioxan, Polycarbosiloxan, Polycarbosilan, Polysilylcarbodiimid, Polysilsesquicarbodiimid, Polysilsesquiazan, Polysilazan, Polyborosilazan, Polyborosilan, Polyborosiloxan und eine Kombination dieser Polymere umfasst.

4. Verbundstruktur (100) nach einem der Ansprüche 1 bis 3, wobei die Matrix (4) mit einem oder mehreren anorganischen Partikeltypen beladen ist, ausgewählt aus:
- einem Wärmeleiter, wie z. B. SiC,
- einem elektrischen Isolator, wie AIN, Si₃N₄, kristallines Al₂O₃ oder BN,
- einem elektrisch leitfähigen Metall, wie z. B. Cu, Ag, Au oder Al,
- einem magnetischen Material, wie NdFeB, ZnMn-Ferrit oder NiZn-Ferrit,
- einem Material mit optischen Eigenschaften,
und einer Kombination dieser verschiedenen anorganischen Partikeltypen.

5. Verbundstruktur (100) nach einem der Ansprüche 1 bis 4, wobei die Matrix (4) aus einer Füllstoffformulierung erhalten wird, die zwischen 20 Vol.-% und 50 Vol.-% des präkeramischen Polymers und eine Füllrate an anorganischen Partikeln von 50 Vol.-% und 80 Vol.-% im Verhältnis zum Gesamtvolumen der Füllstoffformulierung umfasst.

6. Verbundstruktur (100) nach einem der Ansprüche 1 bis 5, wobei der Dünnfilm (9) mit der Oberseite (3) des Trägersubstrats (1) und dem Verbundmaterial (5) über einen auf der Oberseite (3) des Trägersubstrats (1) angeordneten Haftvermittler (6) und auf einer freiliegenden Oberfläche des Verbundmaterials (5), die die Hohlräume (2) füllt, verklebt ist.

7. Mikroelektronisches System (200) mit planarer Kointegration, umfassend:
- eine Verbundstruktur (100) nach einem der Ansprüche 1 bis 6,
- eine Vielzahl von elektronischen Komponenten mit unterschiedlichen Funktionen auf dem Dünnfilm (9), umfassend:
o passive elektronische Komponenten (11), wie z. B. HF-Komponenten, beispielsweise Sensoren, die auf ersten Bereichen der freiliegenden Oberfläche des Dünnfilms (9) ausgebildet sind, die sich senkrecht zum Verbundmaterial (5) befinden und die Hohlräume (2) des Trägersubstrats (1) füllen,
o aktive elektronische Komponenten (10), wie z. B. Transistoren, die mit den HF-Komponenten verbunden sind und auf zweiten Bereichen der freiliegenden Oberfläche des Dünnfilms (9) ausgebildet sind, die sich senkrecht zum ersten Material des Trägersubstrats (1) befinden,
wobei die anorganischen Partikel der Matrix (4) aus SiC und/oder Si₃N₄ bestehen, um dem Verbundmaterial (5), das die Hohlräume (2) ausfüllt, einen wärmeleitenden und elektrisch isolierenden Charakter zu verleihen.

8. Verfahren zur Herstellung einer Verbundstruktur (100), die für eine planare Kointegration bestimmt ist, wobei das Verfahren die folgenden Schritte umfasst:
- a) Bereitstellen eines Trägersubstrats (1) aus einem ersten Material, das eine Oberseite (3) umfasst, wobei das Trägersubstrat (1) Hohlräume (2) umfasst, die in die Oberseite (3) münden,
- b) Füllen der Hohlräume (2) mit einer Füllstoffformulierung, die eine Matrix (4) aus einem präkeramischen Polymer umfasst, wobei die Matrix (4) mit anorganischen Partikeln gefüllt ist,
- c) Anwenden einer Vernetzungsbehandlung, um ein Verbundmaterial (5) zu erhalten, das aus der Matrix (4) des vernetzten präkeramischen Polymers besteht, die mit anorganischen Partikeln beladen ist,
- d) Verkleben eines Donorsubstrats (7) aus einem zweiten Material auf die Oberseite (3) des Trägersubstrats (1) und auf das Verbundmaterial (5), und
- e) Ausdünnen des Donorsubstrats (7), um einen Dünnfilm (9) zu bilden.

9. Herstellungsverfahren nach Anspruch 8, wobei dem Schritt d) ein Schritt i) des Planarisierens der Oberseite (3) des Trägersubstrats (1) und/oder einer freiliegenden Oberfläche des Verbundmaterials (5) vorausgeht, so dass sich die freiliegende Oberfläche und die Oberseite (3) in einer Ebene erstrecken und eine für die Verklebung geeignete Oberfläche bilden.

10. Herstellungsverfahren nach Anspruch 8 oder 9, wobei dem Schritt d) ein Abscheideschritt j) vorausgeht, der das Bilden eines Haftvermittlers (6) auf der Oberseite (3) des Trägersubstrats (1) und der freiliegenden Oberfläche des Verbundmaterials (5) und/oder auf dem Donorsubstrat (7) umfasst, so dass das Verkleben des Donorsubstrats (7) mit dem Trägersubstrat (1) und dem Verbundmaterial (5) mithilfe eines Haftvermittlers (6) erreicht wird.

11. Herstellungsverfahren nach einem der Ansprüche 8 bis 10, umfassend das Durchführen eines Schritts k) des Vorbereitens der Oberseite (3) zwischen Schritt b) und Schritt c), umfassend:
- das Anordnen und Halten eines Abdeckelements (12) gegen die Oberseite (3) des Trägersubstrats (1), indem mindestens die Hohlräume (2) abgedeckt werden,
- das Umdrehen des Trägersubstrats (1), so dass die Füllstoffformulierung durch die Schwerkraft bündig mit der Ebene der Oberseite (3) des Trägersubstrats (1) abschließt.

## Claims

1. A composite structure (100) intended for planar co-integration of electronic components with different functions, the composite structure (100) comprising, from its base to its surface:
- a support substrate (1) made of a first semiconductor material, the support substrate (4) including cavities (2) each opening onto an upper face (3) of the support substrate (1), the cavities (2) being filled by at least one composite material (5) consisting of a matrix (4) of a crosslinked preceramic polymer, the matrix (4) being loaded with inorganic particles,
- a thin film (9) made of a second semiconductor or piezoelectric material, the thin film (9) being bonded to the upper face (3) of the support substrate (1) and to the composite material (5).

2. The composite structure (100) according to claim 1, wherein the cavities (2) have a depth greater than or equal to 10 micrometers.

3. The composite structure (100) according to claim 1 or 2, wherein the preceramic polymer is a silicon-based polymer, and preferably selected from the group comprising a polysiloxane, a polysilsesquioxane, a polycarbosiloxane, a polycarbosilane, a polysilylcarbodiimide, a polysilsesquicarbodiimide, a polysilsesquiazane, a polysilazane, a polyborosilazane, a polyborosilane, a polyborosiloxane, and a combination of these polymers.

4. The composite structure (100) according to any of claims 1 to 3, wherein the matrix (4) is filled with one or more types of inorganic particles, selected from:
- a thermal conductor, such as SiC,
- an electrical insulator, such as AIN, Si₃N₄, crystalline Al₂O₃ or BN,
- an electrically conductive metal, such as Cu, Ag, Au or Al,
- a magnetic material, such as NdFeB, ZnMn ferrite or NiZn ferrite,
- a material with optical properties,
and a combination of these different types of inorganic particles.

5. The composite structure (100) according to any of claims 1 to 4, wherein the matrix (4) is obtained from a filling formulation, comprising between 20% and 50% by volume of preceramic polymer and a filler rate of inorganic particles ranging from 50 to 80% by volume relative to the total volume of the filling formulation.

6. The composite structure (100) according to any of claims 1 to 5, wherein the thin film (9) is bonded to the upper face (3) of the support substrate (1) and to the composite material (5) by means of an adhesion promoter (6) arranged on the upper face (3) of the support substrate (1) and on an exposed surface of the composite material (5) filling the cavities (2).

7. A microelectronic system (200) with planar co-integration comprising:
- a composite structure (100) according to any of claims 1 to 6,
- a plurality of electronic components with different functions on the thin film (9) comprising:
∘ passive electronic components (11), such as RF components, for example sensors, formed on first regions of the exposed surface of the thin film (9) located directly above the composite material (5) filling the cavities (2) of the support substrate (1),
∘ active electronic components (10), such as transistors associated with the RF components, formed on second regions of the exposed surface of the thin film (9) located directly above the first material of the support substrate (1),
the inorganic particles of the matrix (4) are made of SiC and/or Si₃N₄ to impart a thermally conductive and electrically insulating character to the composite material (5) filling the cavities (2).

8. A method for manufacturing a composite structure (100) intended for planar co-integration, the method comprising the steps of:
- a) providing a support substrate (1) made of a first material, comprising an upper face (3), the support substrate (1) comprising cavities (2) opening onto the upper face (3),
- b) filling the cavities (2) with a filling formulation comprising a matrix (4) of a preceramic polymer, the matrix (4) being filled with inorganic particles,
- c) applying a crosslinking treatment so as to obtain a composite material (5) consisting of the crosslinked preceramic polymer matrix (4), filled with inorganic particles,
- d) bonding a donor substrate (7) made of a second material to the upper face (3) of the support substrate (1) and to the composite material (5), and
- e) thinning the donor substrate (7) to form a thin film (9).

9. The manufacturing method according to claim 8, wherein step d) is preceded by a step i) of planarizing the upper face (3) of the support substrate (1) and/or an exposed surface of the composite material (5), such that the exposed surface and the upper face (3) extend in a single plane and form a surface suitable for bonding.

10. The manufacturing method according to claim 8 or 9, wherein step d) is preceded by a deposition step j) comprising the formation of an adhesion promoter (6) on the upper face (3) of the support substrate (1) and the exposed surface of the composite material (5) and/or on the donor substrate (7), such that the bonding of the donor substrate (7) to the support substrate (1) and to the composite material (5) is obtained by means of an adhesion promoter (6).

11. The manufacturing method according to any of claims 8 to 10, comprising performing a step k) of preparing the upper face (3) between step b) and step c) comprising:
- arranging and holding a covering element (12) against the upper face (3) of the support substrate (1), covering at least the cavities (2),
- turning the support substrate (1), so that the filling formulation is brought under gravity to the plane of the upper face (3) of the support substrate (1).
